Europäisches Patentamt

European Patent Office

Office européen des brevets

(19)

(11) Numéro de publication: **0 120 754**
**B1**

(12)

# FASCICULE DE BREVET EUROPÉEN

(45) Date de publication du fascicule du brevet:
**13.01.88**

(51) Int. Cl.⁴: **H 01 G 9/05**

(21) Numéro de dépôt: **84400442.4**

(22) Date de dépôt: **06.03.84**

(54) Composant électronique polarisé et son procédé de fabrication.

(30) Priorité: **18.03.83 FR 8304482**

(43) Date de publication de la demande:
**03.10.84 Bulletin 84/40**

(45) Mention de la délivrance du brevet:
**13.01.88 Bulletin 88/2**

(84) Etats contractants désignés:
**DE GB NL**

(56) Documents cité:
**FR-A-2 079 769**
**FR-A-2 178 847**
**US-A-3 828 227**
**US-A-4 064 611**
**US-A-4 288 842**

(73) Titulaire: **COMPONENTES ELECTRONICOS, Calle H N. 5 Poligono Industrial Fontsana, San Juan Despi Barcelona (ES)**

(72) Inventeur: **Vendrell, José, THOMSON- CSF SCPI 173, bld Haussmann, F-75379 Paris Cedex 08 (FR)**

(74) Mandataire: **Vesin, Jacques, THOMSON- CSF SCPI 173, Bld Haussmann, F-75379 Paris Cedex 08 (FR)**

EP 0 120 754 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1988

### Description

La présente invention concerne un composant électronique polarisé, de forme sensiblement parallélépipédique et sans fil de connexion apparent, pouvant être soudé à plat sur les circuits imprimés et les circuits hybrides. Ce type de composant électronique est habituellement désigné sous l'appellation anglo-saxonne de "chip".

Ces composants se développent actuellement de plus en plus car ils ont l'avantage d'éviter le perçage des circuits imprimés. Ils sont généralement fixés dans leur position définitive par un point de colle puis la carte imprimée est ensuite soudée à la vague. Des composants de ce type couramment disponibles dans le commerce sont par exemple les condensateurs céramiques "chip" de forme parallélépipédique et comportant des terminaisons sous forme d'étriers disposées sur deux faces latérales opposées de ce condensateur.

De tels condensateurs peuvent être obtenus selon le procédé décrit dans le brevet français 2079769. Ce procédé comprend les étapes suivantes : disposer un profilé à section en U, disposer à intervalle régulier lesdits condensateurs entre les deux faces parallèles du profilé, enrober l'intérieur des profilés et les condensateurs ainsi disposés à l'aide d'un matériau de remplissage destiné à les maintenir solidaires les uns des autres, l'ensemble ainsi formé étant ensuite découpé en composants individuels par séparation entre les corps de deux condensateurs successifs.

Pour les composants de type polarisé tels que par exemple, les condensateurs au tantale, les diodes, etc... se pose le problème du repérage de l'anode et de la cathode lorsqu'on veut leur donner la même forme extérieure.

Il est connu du brevet américain 3 588 629 de résoudre ce problème en réalisant des bandes métalliques prédécoupées et en fixant la cathode du composant sur une partie pleine de la bande et l'anode sur une partie solidaire de celle-ci mais séparée par une ouverture, puis de séparer la bande en composants individuels en coupant le contact électrique et mécanique existant entre le support de cathode et le support d'anode. Un tel procédé possède le double inconvénient, d'une part, de nécessiter des bandes métalliques de fixation de découpe précises et très particulières, et d'autre part d'augmenter de façon relativement importate la surface occupée par le composant sur le circuit par rapport à la surface du corps du composant.

Une autre solution connue est décrite dans le brevet français 2178847. Elle consiste à faire passer le fil d'anode dans une ouverture prévue dans une des terminaisons réalisées sous forme d'étriers, les condensateurs étant réalisés un par un.

Le composant électronique polarisé du type "chip" selon l'invention permet de résoudre le problème posé de manière simple. Ce composant qui comporte un corps dont la surface forme cathode ou sortie négative isolée électriquement de l'anode reliée à l'extérieur par un fil d'anode ou sortie positive, le corps comportat un premier étrier métallique entourant ledit corps sur sa face opposée à celle traversée par le fil d'anode, ledit étrier étant fixé à la cathode, un second étrier métallique disposé face au premier, sensiblement parallèlement à celui-ci et fixé au fil d'anode étant prévu, les étriers étant constitués d'une face prolongée par deux bras latéraux, ledit composant étant caractérisé en ce que ladite face du second étrier comporte un pli, sensiblement parallèle aux bras dudit étrier, pli dans lequel est fixé le fil d'anode ou sortie positive, un matériau isolant de remplissage étant disposé entre les deux étriers de manière à enrober le corps et le fil d'anode.

La section des étriers aura de préférence extérieurement une forme de U dont les branches se resserrent légèrement.

Extérieurement, on peut aisément distinguer l'anode de la cathode, puisque sur l'étrier d'anode est disposé un pli longitudinal, de préférence situé au milieu de la face de cet étrier, ce pli longitudinal permettant en outre aux machines d'insertion automatique de composants de repérer mécaniquement ladite face d'étrier. Afin d'améliorer encore les possibilités de repérage automatique des faces du composant, l'une des faces de celui-ci, de préférence celle comportant le pli de fixation du fil d'anode sera en matériau magnétique ou magnétisable.

L'invention concerne également un procédé de fabrication d'un tel composant électronique polarisé du type "chip", ledit procédé comprenant les étapes suivantes : l'on dispose face à face deux profilés de section en U sensiblement parallèlement entre eux et formant étrier, l'un d'entre eux possédant un pli longitudinal sensiblement parallèle aux bras latéraux du U, l'on dispose à intervalle régulier entre les deux étriers les condensateurs en insérant le corps du condensateur dont la surface forme cathode dans l'étrier en forme de U et en insérant le fil d'anode de chaque condensateur dans le pli, les corps des condensateurs et les fils d'anode étant ensuite fixés aux étriers et l'espace entre les étriers et les condensateurs ainsi disposés étant enrobés à l'aide d'un matériau isolant de remplissage destiné à les maintenir solidaires les uns des autres, l'ensemble ainsi formé étant ensuite découpé en composants individuels par séparation entre les corps de deux composants successifs.

L'invention sera mieux comprise à l'aide des exemples de réalisation suivants, donnés à titre non limitatif, conjointement avec les figures qui représentent:

- la figure 1, une vue d'un composant selon l'invention;
- la figure 2, une vue en coupe du composant de la figure 1;
- la figure 3, une vue illustrant le procédé de fabrication des composants selon l'invention.

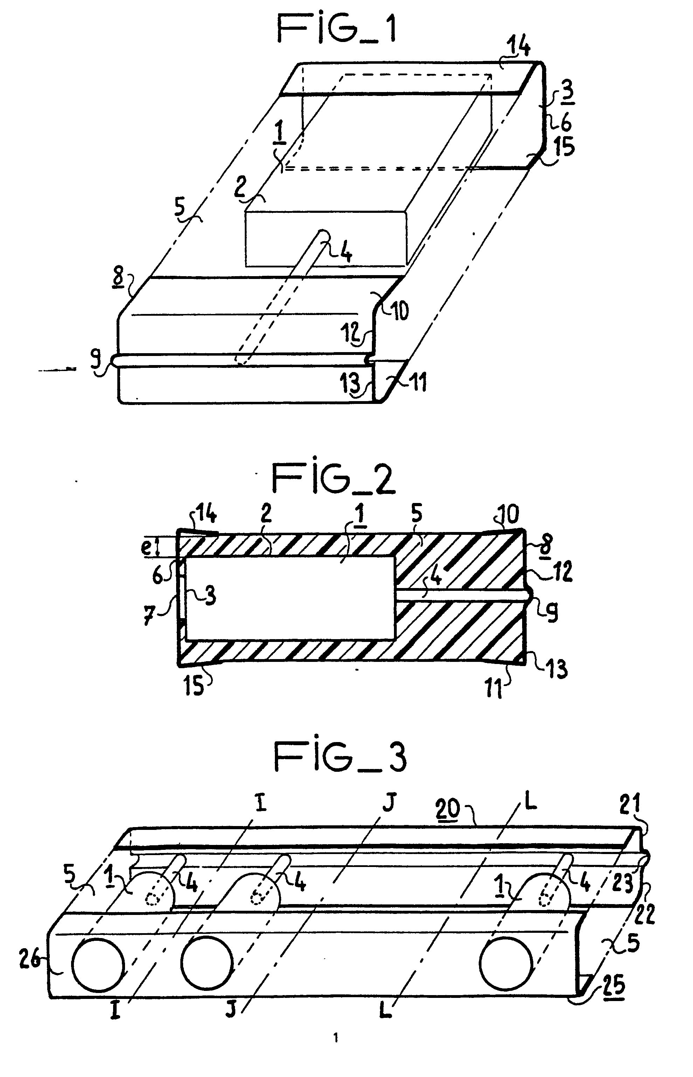

Sur la figure 1, un condensateur électrolytique au tantale 1, connu en soi, est fixé entre deux étriers 3 et 8. Le corps 2 du condensateur 1 est inséré entre les deux bras 14 et 15 reliés entre eux par la face plane 6 de l'étrier 3. Le corps 2 du condensateur 1 dont la surface forme cathode est fixé électriquement et mécaniquement par l'intermédiaire d'une colle conductrice 7 ou d'une brasure à la face plane 6 de l'étrier 3. Le fil d'anode 4 débouchant sur la face du condensateur 1 opposée à celle fixée à l'étrier 3, vient se loger dans le pli 9 de l'étrier 8, pli dans lequel il est de préférence soudé électriquement. Cet étrier 8 comporte lui-même une face plane 12 reliée par l'intermédiaire du pli longitudinal 9 à une seconde face plane 13, l'ensemble des surfaces 12 et 13 étant sensiblement équivalent à la surface 6 de l'étrier 3. Chacune de ces faces 12 et 13 se prolonge respectivement par un bras 10 et 11 sensiblement orthogonal à celle-ci (comme le sont les bras 14 et 15 par rapport à la face 6 de l'étrier 3). Le pli 9 s'étend sur toute la longueur de l'étrier 8, sensiblement parallèlement aux bras 10 et 11, orienté de manière à présenter une saillie sur le composant terminé. Une résine de remplissage telle qu'une résine époxy vient enrober le composant 1 de manière à rendre solidaire les étriers 3 et 8 et le composant 1.

La figure 2 représente une vue en coupe du composant de la figure 1, sur laquelle les mêmes éléments portent les mêmes références. On notera en particulier sur cette figure la distace appellée "e" séparant généralement le corps du composant 1 du bras supérieur 14 de même que celle existant au niveau du bras inférieur 15 de l'étrier 3 (en pratique, e est de l'ordre du millimètre, suffisante pour permettre à la résine d'enrobage d'adhérer sur le corps du composant). De même, on remarquera la longueur du fil d'anode 4, longueur suffisante pour ne pas détériorer les caractéristiques electriques du composant au cours de la soudure du fil d'anode dans le pli. En pratique, pour des condensateurs au tantale, une telle longueur du fil d'anode, de sa sortie du boîtier au fond du pli de l'étrier est de l'ordre de quelques millimètres.

Le composant décrit ci-dessus peut être fixé sur un circuit imprimé par brasage par exemple des bras 11 et 15 des étriers (ou 10 et 14) après fixation par une colle du composant sur le circuit avant brasure à la vague. Les bras de l'étrier seront de préférence traités pour faciliter la brasure. On remarquera que la solution selon l'invention n'augmente pas le volume occupé par le composant. Le resserrement des branches du U de l'étrier permettant de laisser un passage sous le composant après brasure sur le circuit, permet le nettoyage du circuit.

Sur la figure 3, on a représenté schématiquement la mise en oeuvre du procédé selon l'invention, figure sur laquelle les mêmes éléments que ceux des figures précédentes, portent les mêmes références. Les étriers sont respectivement sous la forme de profilés à section en U de grande longueur, disposés face à face. L'un de ces profilés 25 a une face arrière plane 26 tandis que l'autre profilé situé face à lui, 20, comporte une face arrière constituée d'une partie plane 21 d'un pli longitudinal 23 puis d'une seconde partie plane 22. Ces profilés sont disposés de la même manière que les étriers ci-dessus. On introduit alors les composants polarises 1 par translation longitudinale, translation relative par rapport auxdits profilés. Le corps des condensateurs est fixé dans l'étrier correspondant par brasure simultanée après introduction et maintien des composants dans les profilés préalablement revêtus intérieurement d'une couche de brasure, puis on soude électriquement les fils d'anode dans le pli. Lorsque les composants ont été disposés, à intervalle régulier, entre lesdits profilés, de la manière explicitée ci-dessus, on enrobe alors l'ensemble de résine époxy 5, par exemple. Après polymérisation de la résine, on procède au découpage des condensateurs individuels le long des lignes telles que II, JJ, etc... LL. Bien entendu, les métaux qui constituent les étriers sont choisies compatible avec les fils d'anode et de cathode des composants enrobés. En particulier, dans le cas de condensateurs du type tantale envisagés ci-dessus, le nickel, seul ou sous forme d'alliage sera utilisé au moins comme couche superficielle.

**Revendications**

1. Composant électronique polarisé du type "chip" comportant un corps (2) dont la surface forme cathode ou sortie négative isolée électriquement de l'anode reliée à l'extérieur par un fil d'anode (4) ou sortie positive, le corps (2) comportant un premier étrier (3) métallique entourant ledit corps sur sa face opposée à celle traversée par le fil d'anode (4), ledit étrier étant fixé à la cathode, un second étrier (8) métallique, disposé face au premier, sensiblement parallèlement à celui-ci et fixé au fil d'anode étant prévu, les étriers (3, 8) étant constitués d'une face (6, 12, 13) prolongée par deux bras latéraux (14, 15, 10, 11), un matériau isolant (5) de remplissage étant disposé entre les deux étriers (3,8) de manière à enrober le corps (2) et le fil d'anode (4), ledit composant étant caractérisé en ce que ladite face (12, 13) du second étrier (8) comporte un pli (9) sensiblement parallèle aux bras (10, 11) dudit étrier (8), pli (9) dans lequel est fixé le fil d'anode (4).

2. Composant électronique selon la revendication 1, caractérisé en ce que le pli (9) est situé au centre de la face (12, 13) correspondante du second étrier (8).

3. Composant électronique selon l'une des revendications 1 à 2 caractérisé en ce que la distance entre la sortie de l'anode (4) du corps (2) et le pli (9) dans lequel le fil d'anode (4) est soudé électriquement est suffisante pour ne pas détériorer les caractéristiques électriques dudit composant au cours de la soudure de celui-ci dans le pli (9).

4. Composant électronique selon l'une des revendications 1 à 3, caractérisé en ce que le pli (9) est apparent à l'extérieur du composant de manière à réaliser un moyen de repérage pour les machines d'insertion automatique.

5. Composant électronique selon l'une des revendications 1 à 4, caractérisé en ce que l'un des étriers (3, 8) est en matériau magnétique et/ou magnétisable.

6. Composant élctronique selon l'une des revendications 1 a 5, caractérisé en ce que chaque étrier (3,8) comporte au moins un bras (10, 11, 14, 15) situé du même côté par rapport au corps du composant, dont le métal est traité pour faciliter la brasure.

7. Procédé de fabrication d'un composant électronique du type polarisé selon l'une des revendications 1 à 6, consistant à disposer face à face deux profilés (20, 25) à section en U sensiblement parallèlement entre eux et formant étriers, l'un d'entre eux (20) possédant un pli longitudinal (9) sensiblement parallèle aux bras latéraux (21, 22) du U, des condensateurs étant ensuite disposés à intervalle régulier entre les deux étriers (20, 25), l'étrier à section en U (20) sans pli (9) entourant le corps (2) du condensateur dont la surface forme cathode tandis que le fil d'anode (4) desdits condensateurs est glissé dans le pli (23) du second étrier (20), les corps des condensateurs et les fils d'anodes étant ensuite fixés aux étriers et l'espace entre les étriers et les condensateurs ainsi disposés étant enrobés à l'aide d'un matériau isolant de remplissage destiné à les maintenir solidaires les uns des autres, l'ensemble ainsi formé étant ensuite découpé en composants individuels par séparation entre les corps de deux composants successifs.

## Patentansprüche

1. Gepoltes elektronisches Chip-Bauteil, mit einem Körper (2), dessen Oberfläche die Kathode oder den negativen Ausgang bildet und elektrisch gegen die Anode isoliert ist, wobei letztere über einen Anodendraht (4) oder positiven Ausgang nach außen geführt ist, wobei der Körper (2) einen ersten Metallbügel (3), der den Körper an seiner der von dem Anodendraht (4) durchquerten Seite gegenüberliegenden Seite umgibt und der an der Kathode befestigt ist, und einen zweiten Metallbügel (8) aufweist, der dem ersten im wesentlichen parallel gegenüberliegt und am Anodendraht befestigt ist, wobei die Bügel (3, 8) je aus einer Seite (6, 12, 13) und zwei diese verlängernden Armen (14, 15, 10, 11) gebildet werden und ein isolierendes Füllmaterial (5) zwischen den beiden Bügeln (3, 8) angeordnet ist, sodaß der Körper (2) und der Anodendraht (4) eingehüllt werden, dadurch gekennzeichnet, daß die genannte Seite (12, 13) des zweiten Bügels (8) eine im wesentlichen zu den Armen (10, 11) dieses Bügels (8) parallele Falte (9) aufweist, in der der Anodendraht (4) befestigt ist.

2. Elektronisches Bauteil nach Anspruch 1, dadurch gekennzeichnet, daß die Falte (9) sich in der Mitte der entsprechenden Seite (12, 13) des Bügels (8) befindet.

3. Elektronisches Bauteil nach einem der Ansprüche 1 bis 2, dadurch gekennzeichnet, daß der Abstand zwischen dem Ausgang der Anode (4) aus dem Körper (2) und der Falte (9), in der der Anodendraht (4) elektrisch angeschweißt ist, ausreichend groß ist, um nicht die elektrischen Kennwerte des Bauteils während des Einschweißens des Drahts in die Falte (9) zu beeinträchtigen.

4. Elektronisches Bauteil nach einem der Ansprüche 1 bis 3, dadurch gekennzeichnet, daß die Falte (9) außen am Bauteil sichtbar ist, sodaß sie als Orientierungshilfe für die Bestückungsautomaten dient.

5. Elektronisches Bauteil nach einem der Ansprüche 1 bis 4, dadurch gekennzeichnet, daß einer der Bügel (3, 8) aus einem magnetischen und/oder magnetisierbaren Material besteht.

6. Elektronisches Bauteil nach einem der Ansprüche 1 bis 5, dadurch gekennzeichnet, daß jeder Bügel (3, 8) mindestens einen Arm (10, 11, 14, 15) auf einer gemeinsamen Seite des Körpers des Bauteils besitzt, dessen Metall zur Erleichterung des Lötvorgangs behandelt ist.

7. Verfahren zur Herstellung eines gepolten elektronischen Bauteils nach einem der Ansprüche 1 bis 6, nach dem zwei Profilteile (20, 25) mit U-förmigem Querschnitt zueinander parallel und einander gegenüber angeordnet werden, sodaß sie Bügel bilden, wobei einer der Bügel (20) eine im wesentlichen zu den Seitenarmen (21, 22) des U parallele Längsfalte (9) besitzt, worauf Kondensatoren in gleichmäßigen Abständen zwischen den Bügeln (20, 25) angebracht werden, wobei der Bügel (25) ohne Falte (9) den Körper (2) des Kondensators umgibt, dessen Oberfläche die Kathode bildet, während der Anodendraht (4) der Kondensatoren in die Falte (23) des zweiten Bügels (20) gesteckt wird, worauf die Körper der Kondensatoren und die Anodendrähte an den Bügeln befestigt werden und der Raum zwischen den Bügeln und den so angeordneten Kondensatoren von einem isolierenden Füllmaterial erfüllt wird, das sie zusammenhalten soll, worauf die so gebildete Einheit durch Trennung zwischen den Körpern zweier benachbarter Bauteile in Einzelbauteile zerschnitten wird.

## Claims

1. A polarized electronic component of the "chip" type, comprising a body (2) whose surface forms cathode or negative terminal, which is electrically insulated from the anode connected to the outside through an anode wire (4) or positive terminal, the body (2) comprising a first metallic stirrup (3) surrounding that face of the body which is opposed to the anode wire (4) outlet, said stirrup being fixed to the cathode, and a second metallic stirrup (8) disposed in substantially parallel face-to-face relationship with the first one and fixed to the anode wire, the stirrups (3, 8) each being constituted by a face portion (6, 12, 13) to which two lateral arms (14, 15, 10, 11) are added, an insulating filler material (5) being disposed between both stirrups (3, 8) in order to cover the body (2) and the anode wire (4), characterized in that said face portion (12, 13) of the second stirrup (8) comprises a pleat (9) which is substantially parallel to the arms (10, 11) of said stirrup (8) and wherein the anode wire (4) is fixed.

2. An electronic component according to claim 1, characterized in that the pleat (9) is located at the center of the corresponding face portion (12, 13) of the second stirrup (8).

3. An electronic component according to one of claims 1 to 2, characterized in that the distance between the outlet of the anode (4) from the body (2) and the pleat (9) in which the anode wire (4) is electrically welded is large enough for not injuring the electrical characteristics of the component during the welding of the wire in the pleat (9).

4. An electronic component according to one of claims 1 to 3, characterized in that the pleat (9) is apparent from outside the component in order to constitute a guide mark for automatic assembling machines.

5. An electronic component according to one of claims 1 to 4, characterized in that one of the stirrups (3, 8) is made of a magnetic and/or a magnetizable material.

6. An electronic component according to one of claims 1 to 5, characterized in that each stirrup (3, 8) comprises at least one arm (10, 11, 14, 15) located at the same side in respect of the body of the component, the metal of which is treated for facilitating the soldering operation.

7. A method of manufacturing an electronic component of the polarized type according to one of claims 1 to 6, consisting in disposing two profiles (20, 25) of an U-shaped cross-section, facing and substantially parallel to each other such that they build up stirrups, one of them presenting a longitudinal pleat (9) which is substantially parallel to the lateral arms (21, 22) of the U, capacitors being then arranged at regular intervals between the two stirrups (20, 25), the stirrup (25) without pleat (9) surrounding the body (2) of the capacitor whose surface constitutes the cathode while the anode wire (4) of said capacitors is inserted into the pleat (23) of the second stirrup (20), the bodies of the capacitors and the anode wires being then attached to the stirrups, and the interspace between the stirrups and the capacitors thus arranged being filled with an insulating filler material intended to rigidify the assembly thus realized, which then is cut into individual components by separation between two adjacent components.

## FIG_1

## FIG_2

## FIG_3